Europäisches Patentamt

(19) European Patent Office

Office européen des brevets

(11) Publication number: **0 041 830**

**A1**

(12) **EUROPEAN PATENT APPLICATION**

(21) Application number: **81302474.2**

(22) Date of filing: **03.06.81**

(51) Int. Cl.³: **H 03 K 17/96**

(30) Priority: **10.06.80 GB 8018883**

(43) Date of publication of application:
**16.12.81 Bulletin 81/50**

(84) Designated Contracting States:
**DE GB IT**

(71) Applicant: **Kenwood Manufacturing Company Limited**
**Thorn House Upper Saint Martin's Lane**
**London WC2H 9ED(GB)**

(72) Inventor: **Fortune, Patricia Elizabeth**
**Springtide Priors Leaze Lane Hambroke**
**Chichester Sussex(GB)**

(74) Representative: **Marsh, Robin Geoffrey et al,**
**THORN EMI PATENTS LIMITED Blyth Road**
**Hayes Middlesex, UB3 1BP(GB)**

(54) **Touch switch.**

(57) An optical touch switch arrangement (5) is described, wherein a light transmissive area (20a) of a panel (20) is touched by the finger of an operator in order to change the state of operation of a circuit element, such as a heating element (2). The area (20a) is linked optically to a photo-sensitive component (28) and the presence or absence of the finger on that area (20a) influences the amount of light falling on the photo-sensitive component (28). This component (28) develops an electrical signal in response to the light which it receives and circuits are provided to respond to the electrical signal by generating an appropriate control signal for the circuit element.

EP 0 041 830 A1

FIG.1

Croydon Printing Company Ltd.

- 1 -

"TOUCH SWITCH"

The present invention relates to touch switches.

The advantages of touch switches, that is to say switches which can be operated without the moving of any mechanical parts, are well known. Usually they operate by detecting a change in capacitance or resistance brought about by the presence of user's finger adjacent to or in contact with the sensitive area of the switch. In the capacitive type of touch switch, it is necessary to minimise the capacitance associated with the electrical connection between the touch switch electrodes and the associated sensing circuitry because the change in capacitance between the electrodes which occurs in the presence of a user's finger is very small. This has, in general, meant that the circuit board carrying the associated sensing circuitry has had to be mounted in physical proximity to the touch switch. Equally, both the capacitive and resistive type touch switches are sensitive to humidity, particularly in circumstances where condensation of moisture occurs on the front surface of the switch. This is, of course, particularly a problem in a kitchen environment.

According to the present invention we provide a touch switch arrangement comprising a light transmissive member having an area against which in use, a finger is to be applied to operate the switch arrangement and optically coupled by means of at least one optical fibre to an associated, remotely located light responsive element, the arrangement being such that the presence of a finger to said area produces a change in the output of the light responsive element which can be used for switching purposes.

The light transmissive member can be a control panel of a domestic appliance or other device to be controlled by the switch arrangement; where a plurality of touch switches are required, the light transmissive member of each touch switch arrangement can be constituted by a respective section of a common panel of suitable material.

In this way, not only are the above mentioned disadvantages of the capacitive and resistive touch switches eliminated, but the need for electrical wiring to the control panel of the device, which can cause problems in manufacture and also from the safety point of view, is also eliminated.

In one embodiment of the present invention described below with reference to the accompanying drawings, an area of a control panel is optically coupled via a two-way optical fibre arrangement with a remotely located light responsive element, specifically a photodiode, and with a light source, namely a light emitting diode. The optical fibre arrangement directs the light from the LED through the control panel to its front surface; when the user's finger is placed over the surface, a greater than normal amount of the light is reflected back up the optical fibre arrangement to the photodiode causing a change in its output which can be used for control purposes. The light emitted from the photodiode is preferably modulated at a frequency substantially above the normal flicker rate of room lighting, i.e. 100 Hz for a 50 Hz mains supply, so that there is little risk of the photodiode being triggered spuriously. The light emitted by the photodiode may be either visible light, which has the advantage that the area of the control panel which is to be touched for operation of the switch is easily illuminated or, in other circumstances it may be more convenient for the light to be invisible, infra-red radiation e.g. from an infra-red-emitting LED. Optical filtering is preferably also included so that the response of the photodiode is matched with the output of the light emitting diode. In the first illustrated embodiment, at least at the control panel end, the optical fibre arrangement comprises two separate bundles of fibres. One bundle, which is transmitting light from the control panel is fanned out in the form of a cone while the free ends of the other bundle are located within this cone and are directed towards the control panel and transmit the light from the photodiode to it. By having the receptor area surrounding the emitting area of the control panel a certain amount of tolerance to inaccurate positioning of the finger is provided.

The invention will be further described by way of example with reference to the accompanying drawings in which:-

Figure 1 is a schematic block circuit diagram of one embodiment of the present invention;

Figure 2 shows part of the embodiment of Figure 1 in greater detail; and

Figure 3 is a schematic sectional view of part of a further embodiment of the present invention.

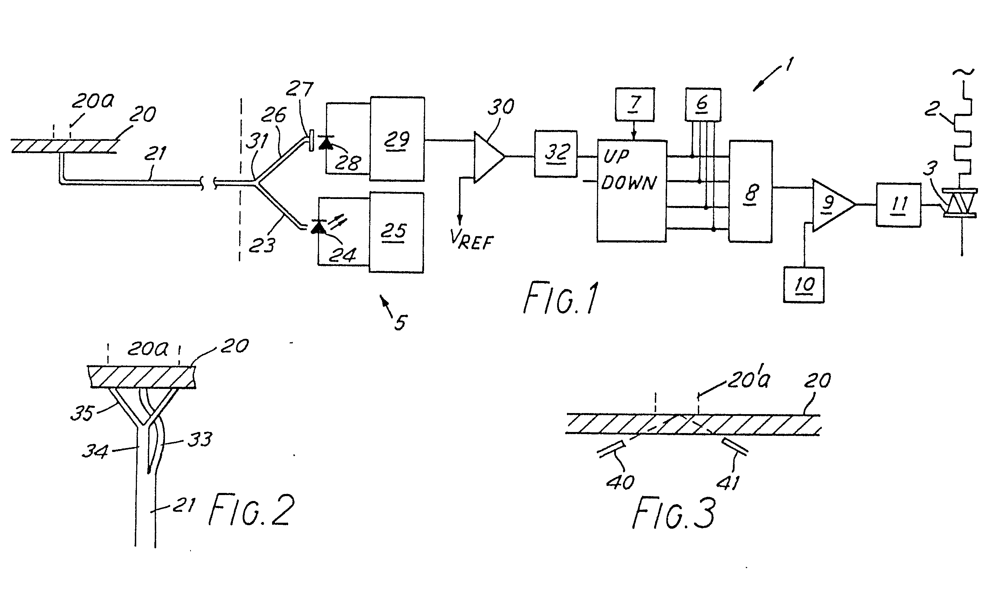

In Figure 1, control circuitry, generally designated 1, serves to control a hotplate heating element 2 of an electric cooking hob. This heating element is connected in series with a triac 3 across the mains supply.

The triac 3 is operated in the burst-fire mode so that the power dissipated in the heating element 2 is dependent upon the count stored in an up/down counter 4, the contents of the counter having previously been set by the user by operation of one or both of two touch switch arrangements which are similar to one another and only of which is shown in Figure 1, being generally designated 5.

The two touch switch arrangements 5 are connected to the "up" and "down" inputs respectively of the counter 4 so that the counter will progressively count upwards or downwards depending on which of the two touch switch arrangements is activated and count at a rate determined by a low frequency pulse source 7 which delivers pulses at a rate of between, for example, two and five Hz. The output of the counter is delivered to a display 6 which displays to the user the present count and also to a digital to analogue converter 8 where a DC voltage is produced proportional to the count held by the counter. This DC voltage is compared by a comparator 9 with the output of a free running ramp generator 10 of which the ramp frequency is several, say 20, seconds. While the output of the ramp generator is below the output of the digital to analogue converter, the comparator 9 is in one state and causes a triac gate drive circuit 11 to turn on the triac for successive half cycles of the mains supply waveform. When the ramp level exceeds the output of the digital to analogue converter, the comparator output changes state, disabling the triac gate drive 11.

In use, therefore, the user notes the present heating level and, according to whether the heating level is to be increased or decreased activates one of the two touch switch arrangements 5. All the while one of the two touch switches is activated, the counter 4 is progressively clocked upwards or downwards by the pulse source 7. Once the heating level has been set to the desired new value, the user then removes his or her finger from the touch switch arrangement.

The light transmissive members of the two touch switches 5 are constituted by respective portions of a common, light transmissive, control panel 20 made, for example, from a suitable plastics material. A bundle of optical fibres 21 extends from the rear of the control panel 20 opposite the responsive area 20a to the remoate location where the associated detecting circuitry and control circuitry for the heating element 2 are placed. As its inner end, the fibre bundle 21 is provided with a Y-piece 31 so that it splits into two smaller bundles 23 and 26 each comprising at least one optical fibre. The bundle 23 is optically coupled with a light emitting diode 24 which is energised from a pulse source 25 so that its light output is modulated at a frequency substantially higher than the flicker rate of mains-energised room lighting, i.e. 100 Hz for a 50 Hz mains supply. This modulation is to provide a detectable signal which is distinguishable from stray light signals which may be picked up from room lighting.

The other bundle 26 is optically coupled with a photodiode 28 which is connected to a circuit 29 which comprises a narrow band pass filter tuned to the frequency of the source 25 and a charge pump arrangement for rectifying and smoothing the output of this filter so as to provide at one input of a comparator 30 a smoothed DC level representing the amouunt of the signal from the light emitting diode 24 which is being received by the photodiode 28. When a user places his or her finger on the responsive area 20a of the touch switch, light from the light emitting diode 24 shining through the panel 20 towards its front face is reflected back up the optical fibre bundle to the photodiode 28, causing an increase in its output and hence an increase in the output from the circuit 29. This output is compared with a reference level by comparator 30, the reference level being suitably chosen so that the output of comparator 30 is applied to a circuit 32 which comprises a monostable. This is arranged so that when the output of comparator 30 changes state indicating that the presence of the user's finger on the area 20a, the output of circuit 30 also changes state. If, however, the user's finger remains on the area 20a for an inordinately long time, the monstable multivibrator times out and the output of the circuit 32 goes low. This is a safety feature to help reduce the risk of improper operation resulting from, for example, an article being stood on or near the area 20a.

The output of circuit 32, is, for the touch switch arrangement 5 shown in Figure 1 connected to the "up" input of counter 4. A similar touch switch 5 is also connected to the "down" input.

Figure 2 shows in greater detail one way in which the optical fibre bundle 21 may be optically coupled with the control panel 20. At its outer end the bundle is divided into two smaller bundles 33 and 34 which contain the fibres of the bundles 23 and 26 respectively so that bundle 33 acts as a light input to the control panel 20 whereas the fibres of the bundle 34 act as receptors of light from the panel. As shown, the outer-most ends 35 of the receptor bundle 34 are arranged, e.g. by means of an adhesive, in the form of a cone 35 with the end faces of the fibres against the control panel 20. The fibres of the bundle 33 pass through the wall of the cone defined by the fibre ends 35 and are optically coupled to the control panel 20 at the centre of the base of this cone. The fibre ends 30 thus define an annular receptor area at the centre of which is located the light input area from the bundle 33.

For two or more touch switches, the pulse sources and associated filters may, if respective, be tuned to respective different frequencies to prevent interaction between different touch switches which might occur through light scatter in the material of control panel 20.

The cone 35 may be a separate moulding of plastics or other suitable material to which the bundle 21 is optically coupled.

In those circumstances the cone may be designed to act as a lens to concentrate the light from the user's finger onto the ends of the receptor fibres and have a central cylindrical portion coupled to the fibres 33 for coupling the light from the fibres 33 into the pnael.

Figure 3 shows part of a further form of touch switch which may be used in the embodiment of Figure 1. Here the optical fibre bundle corresponds to the optical fibre bundle 21 in Figure 1 but divides at its end adjacent the panel into an input branch 40 and a receptor branch 41 contained in a common plane perpendicular to the major surfaces of the panel and at equal, oblique angles to it. Both branches are directed at a common area 20a on the upper surface of the panel so that when a user places a finger on that area a greater proportion of the light from the input branch 40 is directed to the receptor branch 41.

It is not, of course, necessary to use visible light in the touch switches and instead infra-red light may be used. For this purpose the diode 24 can be infra-red emitting in this event the photodiode 28 infra-red sensitive. Whether the light is infra-red or visible, the photodiode 28 may have associated with it an optical filter 27 so that its response is tuned to a desired range of wavelengths. Infra-red light and/or such filtering may, of course, also be used in the versions of the touch switch shown in Figure 2 and 3.

In our co-pending Application No. 8009807 we describe a control device intended to replace the conventional potentiometer in certain applications. In its rotary form (a slider form is also possible) it comprises an optical encoder disc rotatable by means of a knob and having a number of concentric optical encoding tracks on it. Light transmitted through, or alternatively reflected from, the tracks of the disc is detected by respective photodiodes the outputs of which produce a unique code for each one of a number of angular positions of the disc. This code may be used in its digital form or converted to an analogue signal for analogue control purposes. In one form, the light source, a light emitting diode, and the photodiodes are remotely located and coupled to the control by means of optical fibre bundles. It will be appreciated that in embodiments of the present invention where potentiometer-like controls are required, these optical encoder control devices using optical fibre bundles may be used instead, so eliminating the need to take electrical wiring to the control panel of the device.

It is, of course, also possible to eliminate the need for wiring to the front panel for panel lights, etc., by locating these remotely also and optically coupling them with the front panel via fibre optic bundles.

Although the invention has been described with reference to its application to a cooking hob, it will be apparent that it may equally well be applied to the control of other heating elements and functions of an electric cooker and to various other domestic appliances and other devices such as food mixers, washing machines, dish washers, tumble driers, etc. and indeed other industrial devices.

What we claim is:

1. A touch switch arrangement comprising a light transmissive member having an area against which, in use, the finger of an operator is to be applied, a light responsive member located remotely from said light transmissive member and coupling means for optically coupling the light transmissive member to the light responsive member, the arrangement being such that the application of an operator's finger to said area influences the amount of light conveyed by said coupling means to said light responsive member.

2. An arrangement according to Claim 1 wherein said coupling means comprises one or more optical fibres.

3. An arrangement according to either of Claims 1 or 2 including a light source and further coupling means optically coupling said light source to said light transmissive member.

4. An arrangement according to Claim 3 wherein said light source is located close to said light responsive member but is optically shielded therefrom to inhibit the direct transmission of light from said source to said responsive member.

5. An arrangement according to either of Claims 3 or 4 wherein said further coupling means comprises one or more optical fibres.

6. An arrangement according to any of Claims 3-5 including means for modulating the amplitude of light emitted said light source, at a frequency different from those associated with other amplitude fluctuations of light occurring in the vicinity of said light transmissive area.

7. An arrangement according to any of Claims 3-6 wherein said first-mentioned coupling means and said further coupling means are coupled respectively to an annular zone of said area and to a central zone of said area, substantially concentric with said annular zone.

8. An arrangement according to any of Claims 3-7 wherein said light source comprises a light-emitting diode and associated circuit components.

9. An arrangement according to any preceding claim wherein said light responsive element comprises a photodiode.

10. An arrangement according to any preceding claim wherein said area comprises one of several similar areas, one each for a number of similar switch arrangements, formed in a common panel of plastics material.

11. An arrangement according to any preceding claim wherein said light responsive member responds to the light coupled thereto to develop an electrical output signal and circuit components are provided to receive said output signal and, in response thereto, to control the operation of a circuit element in accordance with the command conveyed by the application of said operator's finger to said area.

12. An arrangement according to Claim 11 wherein said circuit element comprises a heater element of an electric cooker.

13. An arrangement according to Claim 12 wherein said circuit components include means for generating timing pulses, means for counting said timing pulses and means for displaying the count held by said counter, the arrangement being such as to permit said count to increase only during the application of said operator's finger to said area.

14. An arrangement according to Claim 13 including means for causing said counter to revert automatically to a low count in the event that said count continues to increase for longer than a predetermined time interval.

0041830

FIG.1

FIG.2

FIG.3

European Patent Office

**EUROPEAN SEARCH REPORT**

EP 81 30 2474.2

| DOCUMENTS CONSIDERED TO·BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | GB - A - 1 334 544 (RANK ORGANISA-TION LTD.) | | H 03 K 17/96 |
| | * page 1, lines 28 to 57; page 2, lines 25 to 56 and lines 87 to 128; fig. 1; | 1,3 | |
| | page 1, lines 69, 70; | 2,5 | |
| | page 2, lines 69 to 72; fig. 2 * | 7 | |
| | -- | | |
| | DE - A - 2 128 100 (H. WAGNER) | 1,3 | |
| | * claims 1, 6, 8 and 9; page 4, lines 1 to 5 * | | TECHNICAL FIELDS SEARCHED (Int. Cl.³) |
| | -- | | H 03 K 17/78 |
| | DE - A1 - 2 517 030 (R. LIEDTKE) | | H 03 K 17/94 |
| | * claim 1; page 6, line 31 to page 7, line 2; fig. 12; | 1 | |
| | claim 3; | 3,5 | |
| | claim 2 * | 8,9 | |
| | -- | | |
| | US - A - 3 621 268 (K. FRIEDRICH et al.) | | |
| | * column 2, lines 21 to 25; fig. 2, position 4 * | 1,10 | CATEGORY OF CITED DOCUMENTS |
| | -- | | |
| A | DE - A1 - 2 824 399 (A. BERGSTRÖM) | | |
| | * fig. 3, position 8; | 1,10 | |
| | claim 12; | 6 | |
| | claim 11 * | 8 | |
| | -- | | |
| | ./.. | | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | The present search report has been drawn up for all claims | | |
|---|---|---|---|
| Place of search | Date of completion of the search | Examiner | |
| Berlin | 04-08-1981 | ARENDT | |

EPO Form 1503.1   06.78

0041830

European Patent
Office

EUROPEAN SEARCH REPORT

Application number

EP 81 30 2474.2
- page 2 -

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| A | <u>GB - A - 1 529 862</u> (THORN DOMESTIC APPLIANCES (ELECTRICAL) LTD.) <br> * page 3, line 90 to page 4, line 45; fig. 3 * | 11-13 | |
| P | <u>EP - A1 - 0 025 763</u> (SAINT-GOBAIN VITRAGE et al.) <br> * fig. 2, 4 * | 1,10 | |
| A | <u>US - A - 3 340 401</u> (J.E. YOUNG) <br> * column 3, lines 20 to 34; fig. 2 * | | TECHNICAL FIELDS SEARCHED (Int. Cl.³) |
| | <u>US - A - 3 937 952</u> (L.G. RIPLEY et al.) <br> * column 3, lines 36 to 53; fig. 6 * | 1 | |